# EUROPEAN PATENT SPECIFICATION

(11) **EP 3 899 991 B1**
(45) Date of publication and mention of the grant of the patent: **11.11.2026**
(21) Application number: 19898070.8
(22) Date of filing: 18.12.2019
(51) Int. Cl.: H01C 1/082, H01H 9/52, H10W 40/60, H10W 40/73, H01C 7/12, H01H 9/54

(54) **COOLING OF POWER SEMICONDUCTORS**
KÜHLUNG VON LEISTUNGSHALBLEITERN
REFROIDISSEMENT DE SEMI-CONDUCTEURS DE PUISSANCE

(30) Priority: 19.12.2018 US 201862781861 P
(43) Date of publication of application: 27.10.2021
(73) Proprietor: ABB Schweiz AG, 5400 Baden (CH)
(72) Inventor: TSCHIDA, Colin, Durham, North Carolina 27705 (US); CAIROLI, Pietro, Cary, North Carolina 27511 (US); KIM, Hongrae, Cary, North Carolina 2519 (US); AGOSTINI, Francesco, 8005 Zurich (SE); RACITI, Luca, 24125 Bergamo (IT); LEONI, Davide, 24069 Trescore Balneario (IT)
(74) Representative: Maiwald GmbH
(86) International application number: PCT/US2019/067193
(87) International publication number: WO 2020/132081

(56) References cited:
- EP-A1- 2 328 172
- EP-A1- 2 562 808
- EP-A2- 1 037 515
- WO-A1-2018/015151
- WO-A1-2018/222842
- WO-A1-2018/222842
- US-A- 6 087 800
- US-A1- 2012 218 684
- US-A1- 2012 218 684
- US-A1- 2013 250 490
- US-B1- 6 448 676

## Description

### BACKGROUND

The present inventions relate generally power semiconductors and cooling thereof.

Power semiconductors can dissipate significant amounts of heat which must be removed to keep the device at a reasonable operating temperature (i.e., 125 °C). Traditionally, this is accomplished with bulky heat sinks or liquid cooling. Some products have used Cothex two-phase thermosiphon based cooling to provide greater power density than heat sinks without the auxiliary pumps required for liquid cooling. Unfortunately, the geometry of power semiconductors (e.g., round shape for IGCTs) is not the same as the base-plate of these two phase cooling systems so that they must operate in a less effective hot-spot configuration. Heat spreaders are also often used in power-electronic cooling. Some examples of heat spreaders are thermal interface pads (e.g., graphite pads), copper or aluminum plates, copper plates with embedded heat pipes, and vapor chambers (like a two dimensional heat pipe). It is desirable to spread the heat across the entire area of the base-plate but this is not easy to accomplish without adding cost and Pertinent prior art concerned with arrangements of circuit breakers and cooling systems are found in Patent documents EP 1037515A2, WO 2018/222842A1 and EP 2328172A1.

### SUMMARY

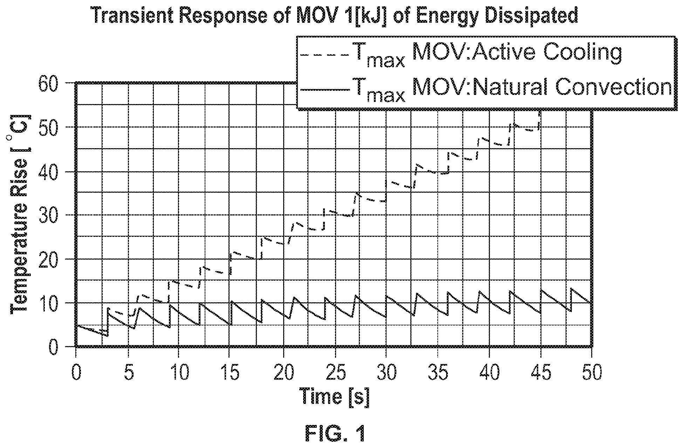

The present invention provides a solid state circuit breaker according to claim 1. Embodiments of the invention are set forth with the appended dependent claims. In the following, a new configuration is described for operating a solid-state circuit breaker in repetitive operation. This is particularly critical when the circuit breaker has the requirement of multiple reclosing actions after a fault. The state of the art involves natural convection cooling of the surge arrester. As shown in Figure 1 (the top line in the chart), natural convection cooling allows a surge arrester to steadily rise in temperature in repetitive operation. It may take the surge arrester more than 30 minutes to cool down after use. As also shown in Figure 1 (the bottom line in the chart), the described configuration allows repeated closing and openings with 3 second intervals without excessive oversizing of the surge arrester components. A metallic heat spreader (e.g., copper, aluminum, or a two-phase device) in between the power semiconductor and base-plate of the cooling element is also described. The bus bar and heat spreader may be combined into the same element so that the additional part count, cost, and complexity are minimized while at the same time enhancing the performance of the cooling system by decreasing the thermal resistance.

### BRIEF DESCRIPTION OF SEVERAL VIEWS OF THE DRAWINGS

The invention may be more fully understood by reading the following description in conjunction with the drawings, in which:
Figure 1 is a chart showing active cooling and natural convection of a MOV during repetitive operation;
Figure 2 is a front view of a double sided cooling configuration of a surge arrester for a solid state circuit breaker;
Figure 3 is a front view of a single sided cooling configuration for the MOV;
Figure 4 is a schematic of a solid state circuit breaker;
Figure 5 is a chart showing the performance of a heat spreader relative to a PHP without a heat spreader;
Figures 6A-6B are views of one configuration of a solid state circuit breaker;
Figures 6C-6D are views of another configuration of a solid state circuit breaker;
Figures 7A-7B are temperature simulations with a heat spreader and without a heat spreader;
Figure 8 is a perspective view of one side of an active cooling system; and
Figure 9 is a perspective view of the other side of the active cooling system, showing a bus bar pressed thereagainst.

### DETAILED DESCRIPTION

Benefits of the arrangement described herein include:
1. Double sided cooling configuration for repetitive operation of a surge arrester in a solid state circuit breaker.
2. Enable repetitive operation and reclosing function for solid state circuit breakers.
3. Minimization of surge arrester requirements and volume.
4. Increased power density.

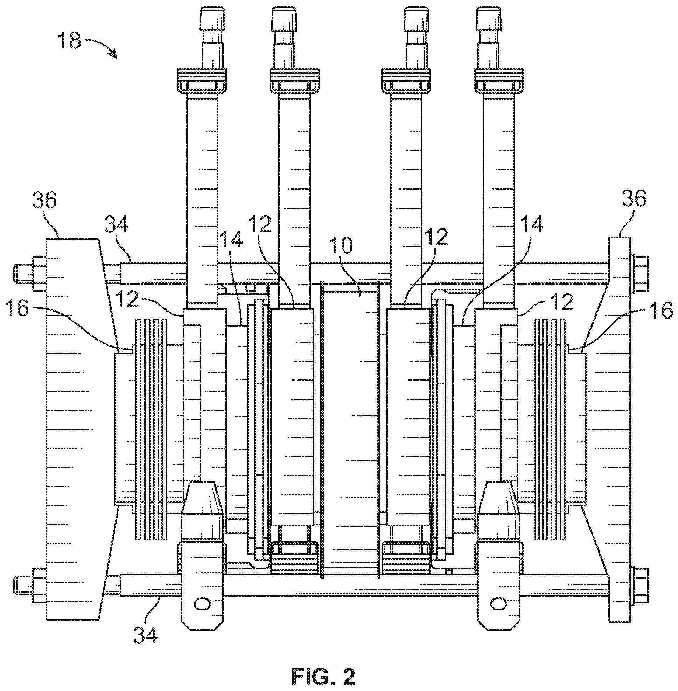

In the proposed configuration, the MOV 10 (metal-oxide varistor) is placed in the stack 18 which has the dual effect of cooling the MOV 10 and simplifying the bus-bar lay-out. An illustration of the proposed configuration is shown in Figure 2. As shown, the MOV 10 is in the center of the circuit breaker 18, and active cooling systems 12 (e.g., PHPs) are on each side of the MOV 10. A power semiconductor 14 (e.g., IGCT) is on the other side of each PHP 12. The IGCTs 14 are against the PHPs 12 and the PHPs 12 are against the MOV 10 such that there are no active components therebetween. Some pulsating heat pipe (PHP) 12 configurations are "single sided" where the device is only designed to provide cooling from the face that is in contact with the IGCT 14. However, active cooling is still provided from the other face with a slightly increased thermal resistance. Insulators 16 are provided on the outer ends of the stack 18. It is understood that other types of power semiconductors may be used for the IGCT 14, including thyristors, A-IGCTs, RB-IGCTs, GTOs or others. Other types of coolers may also be used for the PHP 12, including two phase coolers, PHP, Cothex, hybrid Cothex, etc.

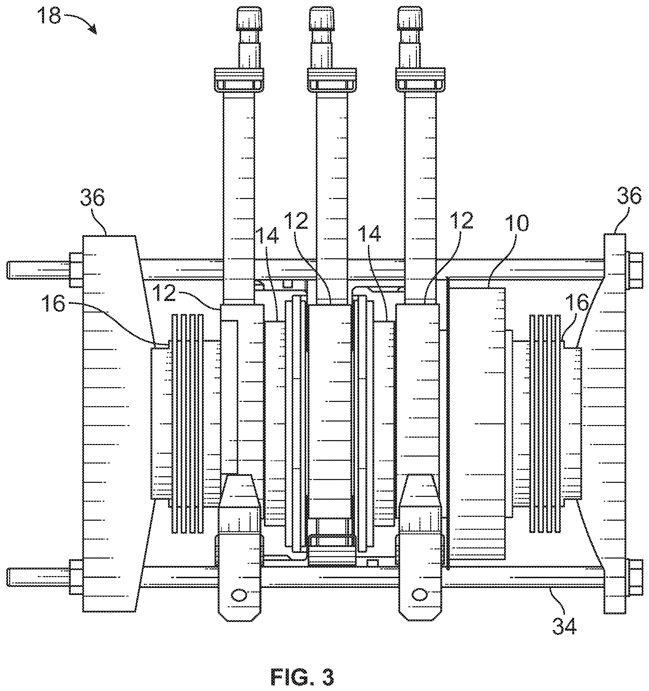

As shown in Figure 3, it is also possible to insert the MOV 10 in the stack 18 and only cool from one side. However, this reduces the cooling available for the MOV 10 and adds some additional complexity for bus-bar layout for the MOV 10.

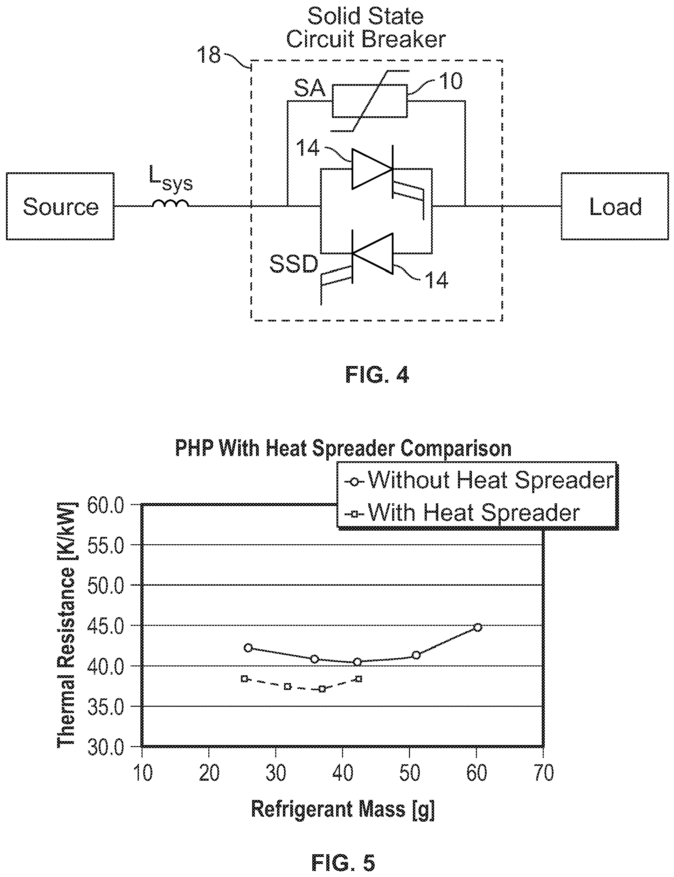

A schematic of a solid state circuit breaker 18 is shown in Figure 4.

The described configuration may be used in solid state circuit breakers that are characterized by ultra-fast opening speed, high number of operations, repetitive operation, reclosing function, and high power density.

The typical voltage range for the cooling arrangement is 50V to 2,000V and 100A to 5,000A. However, the cooling arrangement could also be used for higher voltages and current requirements.

The problems that the described cooling arrangement overcomes include:
1. High temperature and poor cooling of the surge arrester during repetitive operation of a solid state circuit breaker.
2. Oversizing of the surge arrester due to multiple power impulses during repetitive operation and reclosing action of the solid state circuit breaker.

Advantages of the described cooling arrangement include:
1. Enabling repetitive operation and reclosing function for solid state circuit breakers.
2. Minimization of surge arrester requirements and volume.
3. Increased power density.

Thus, the cooling arrangement enables the development of solid state circuit breakers that can perform repetitive operations and reclosing function with higher power density, smaller size, and higher current capability and lower cost.

Figure 5 illustrates the performance of the described heat spreader (bottom line) relative to an unaided PHP (top line). The illustrated data is for dry contacts (no thermal paste) and R245fa as the working fluid. Note that the maximum difference is approximately 10%.

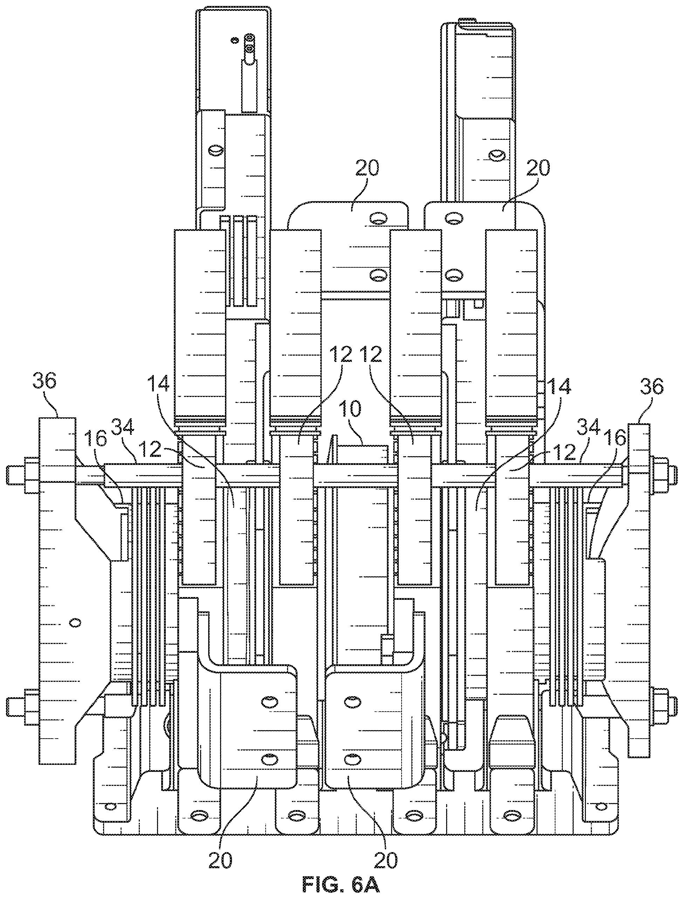

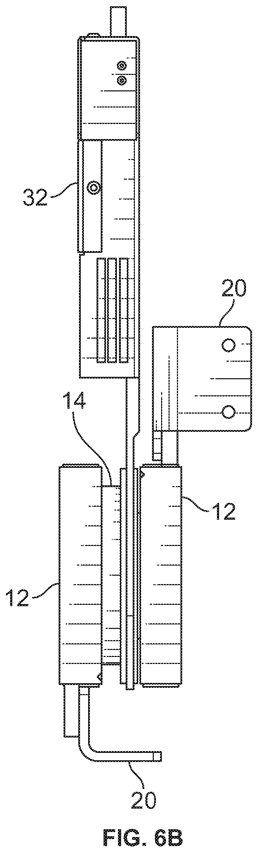

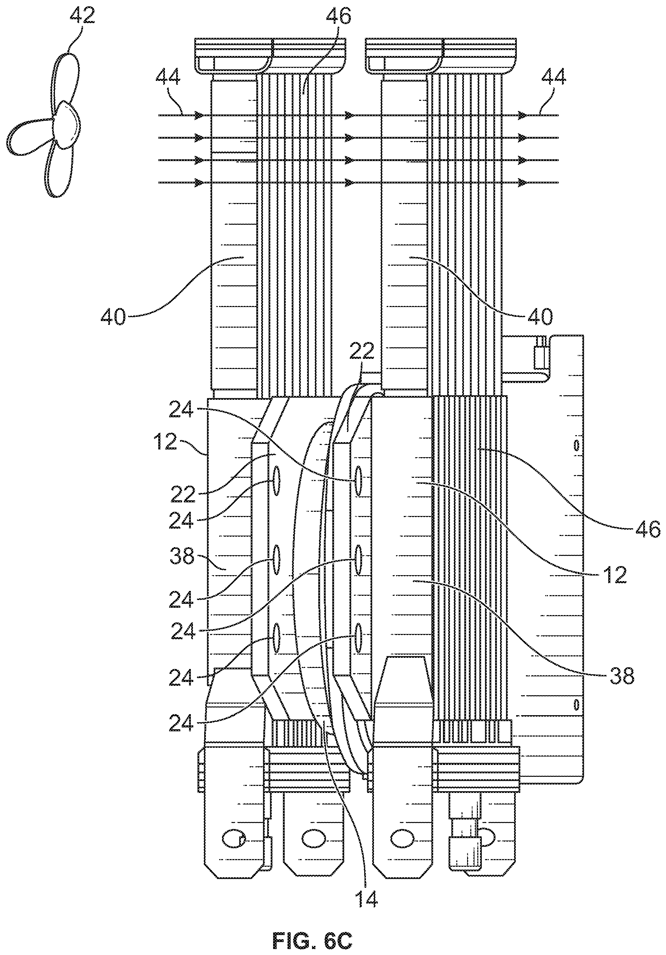

In Figures 6A-6D, pulsating heat pipe (PHP) cooling elements 12 are shown that may result in a 10% reduction in thermal resistance with a copper plate. It may be possible to achieve further reductions with optimization of the plate thickness and thermal interface. One configuration of a DC solid state circuit breaker 18 with PHPs 12 is shown in Figure 6A-6B, showing the bus bar 20 layout. A single IGCT 14 of Figure 6A is shown in Figure 6B. Figures 6C-6D show an improved heat-spreader bus bar 22 that may achieve a 10% reduction in thermal resistance with a copper plate. In the embodiment of Figures 6C-6D, the bus bar 22 is sandwiched between the pulsating heat pipe 12 and the IGCT 14 to conduct heat from the IGCT 14 to the pulsating heat pipe 12 across the thickness of the bus bar 22. Preferably, the bus bar 22 is metallic and may be made of copper or aluminum. The bus bar 22 is an integral component that forms a heat spreading plate between the pulsating heat pipe 12 and the IGCT 14 and extends at least partly beyond the outer circumference of the pulsating heat pipe 12 and the IGCT 14 to provide exposed connectors 24.

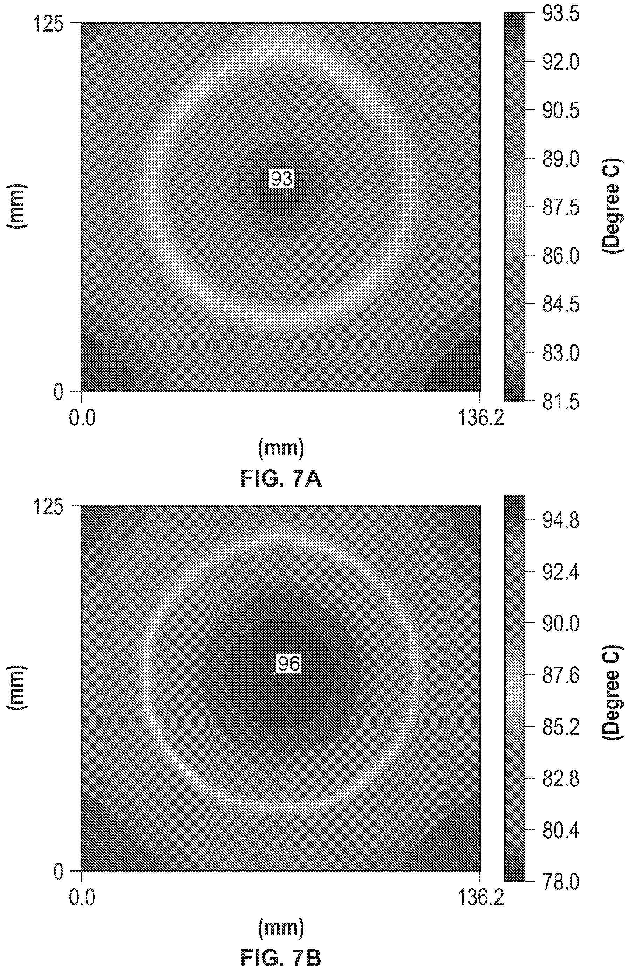

Based on simulations (Figures 7A-7B), the copper plate homogenizes the temperature distribution on the base plate but does not greatly reduce the junction temperature. Figure 7A shows the case temperature of an IGCT with a 6.3mm copper heat spreader mounted to a Cothex cooling element with a temperature variation of 6K across the disk, and Figure 7B shows the case temperature of the same device without the copper spreader showing a 9K variation. The result is a similar device rating but with less imposed thermal stress and therefore better reliability. In one case, a maximum temperature difference of 26 K was measured on the surface of an IGCT device cooled with PHPs at 2 kA current (~2 kW heat losses). The same PHP device was also tested with a copper heater having the same contact area of the IGCT and a maximum temperature difference of 17 K was measured at the same boundary conditions. Since a copper heater represents an "ideal" IGCT device with the best spreading possible to achieve (in the IGCT packaging there is also molybdenum as material), these results showed that there is room for improving the IGCT temperature distribution.

If the thermal conductivity of the base plate is further improved (e.g., with a vapor chamber) then the junction temperature can be reduced by 6K for the same thermal load while the temperature distribution is homogenized.

Advantages of the described arrangement include:
1. The base-plate temperature is homogenized to reduce thermal stress on the semiconductor and results in better reliability.
2. Better utilization of the base plate of the cooling element due to better heat spreading.
3. A low cost solution (copper or aluminum plate).
4. If an aluminum plate is used, it can be brazed during the cooler manufacturing process (also a copper nickel-plated plate can be brazed).
5. Additional electrical resistance is not added due to contacts.
6. In the case of stacking several power semiconductor devices in series, better utilization is possible of outer cooling elements of the stacks which receive heat only from one side.
7. The use of thermal paste or other thermal contact mediums is possible at the added interface since this interface will not be conducting electricity.
8. Higher electrical conductivity of bus bar/heat spreader will slightly reduce local losses in either AC or DC operation.

The preferred arrangement may include a heat spreader (made for instance by a nickel plated copper) for power semiconductor stacks which is also a bus bar. The arrangement by virtue of its mechanical layout also may only conduct electricity through one interface and heat through two, reducing electrical losses due to additional contact resistance. The arrangement may also be produced from a same (Aluminum) or higher (Copper) electrical conductivity material than the cold plate element, minimizing AC/DC electrical losses in that element.

The described arrangement could be modified to improve performance by using aluminum copper clad as material for the cooling unit baseplate, adding heat pipes to the heat spreader/bus bar, incorporating a vapor chamber into the bus bar, or manufacturing the heat spreader out of a layer of materials which have different material properties, higher electrical conductivity or thermal conductivity.

As shown in Figures 6C-6D, the bus bar 22 is sandwiched between an active cooling system 12 and a power semiconductor 14. Since the bus bar 20 is metallic, heat generated by the power semiconductor 14 is conducted 30 away from the power semiconductor 14 to the active cooling system 12 through the thickness of the bus bar 22. A portion of the bus bar 22 also extends beyond an outer edge of the active cooling system 12 and the power semiconductor 14 to provide an exposed electrical connector 24. The bus bar 22 may be a copper plate 22 between the active cooling system 12 and the power semiconductor 14. As shown in Figure 6C, the exposed electrical connector 24 may be a hole 24 through the bus bar 22.

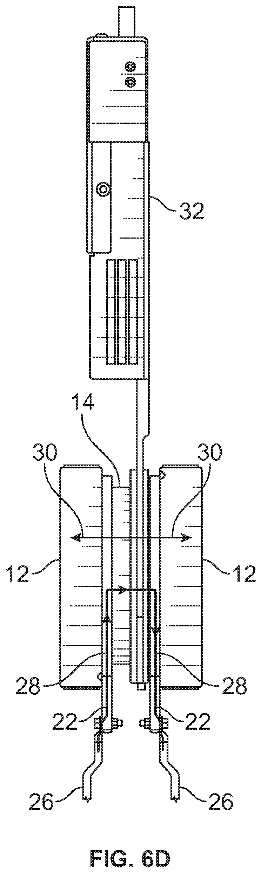

As shown in Figure 6D, separate bus bars 22 are preferably pressed against each side of the power semiconductor 14 (i.e., opposite sides). An electrical conductor 26 may also be connected to the electrical connector 24 of each bus bar 22. In use, different voltage potentials are applied to each of the electrical conductors 26 (e.g., a positive potential and ground). As a result, current 28 flows from one conductor 26, through the attached bus bar 22, through the corresponding side of the power semiconductor 14, the power semiconductor 14, out the other side of the power semiconductor 14, through the other bus bar 22, and to the other electrical conductor 26. As understood, current flow 28 through the power semiconductor 14 is controlled by a gate driver 32 which may extend outward from the power semiconductor 14. Thus, the gate driver 32 turns the power semiconductor 14 on and off to allow current flow 28 therethrough and to block current flow 28. Unlike other arrangements where the electrical connector 24 may be attached to the active cooling system 12 (e.g., Figure 6B), the current 28 does not flow through the active cooling system 12. Even so, it is likely that the voltage potential applied by the conductors 26 will also be incidentally applied to the active cooling systems 12 where the contact between the bus bar 22 and the active cooling system 12 is not insulated due to the desire to transfer heat through the bus bar 22 to the active cooling system 12.

As shown in Figures 2 and 6A, the circuit breaker 18 may have a surge arrester 10 in the center between two power semiconductors 14 (see for reference Figure 4). In this arrangement, an active cooling system 12 may be located between each of the power semiconductors 14 and opposite sides of the surge arrester 10. Each of the power semiconductors 14 may have an active cooling system 12 on opposite sides thereof with a bus bar 22 between each active cooling system 12 and each side of the power semiconductors 14 as described above. The circuit breaker 18 may also include clamps 34 and clamping members 36 at opposite ends of the circuit breaker 18 to press the surge arrester 10, active cooling systems 12, power semiconductors 14 and insulators 16 together in a stack.

As shown in Figure 6C, each of the active cooling systems 12 may have an evaporator section 38 and a condenser section 40. The evaporator section 38 is pressed against the bus bar 22 to receive heat therefrom. The condenser section 40 extends beyond the outer edge of the bus bar 22 and power semiconductor 14 to dissipate the heat. Preferably, a fan 42 may be provided to blow air 44 through the condenser section 40 to transfer heat into the air 44.

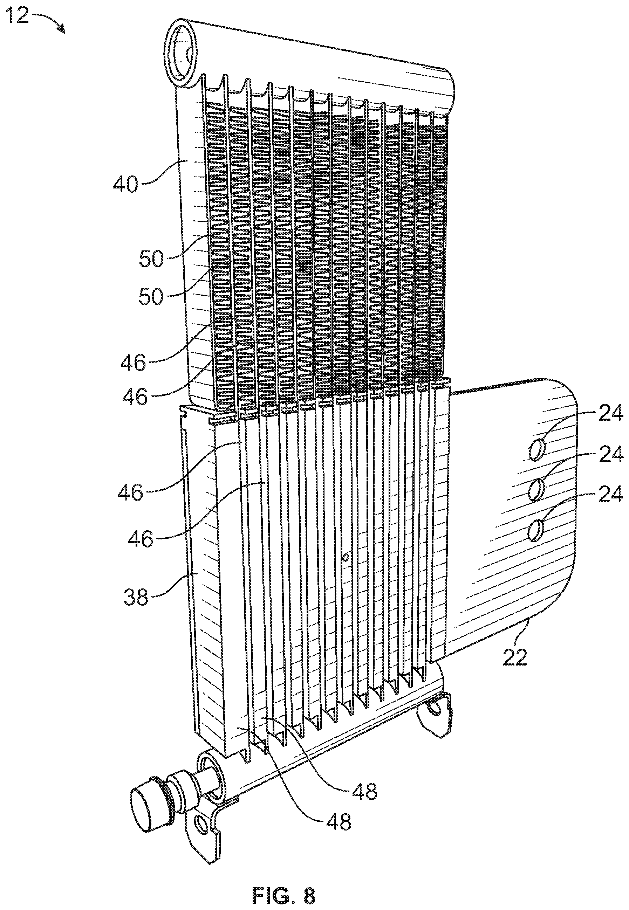

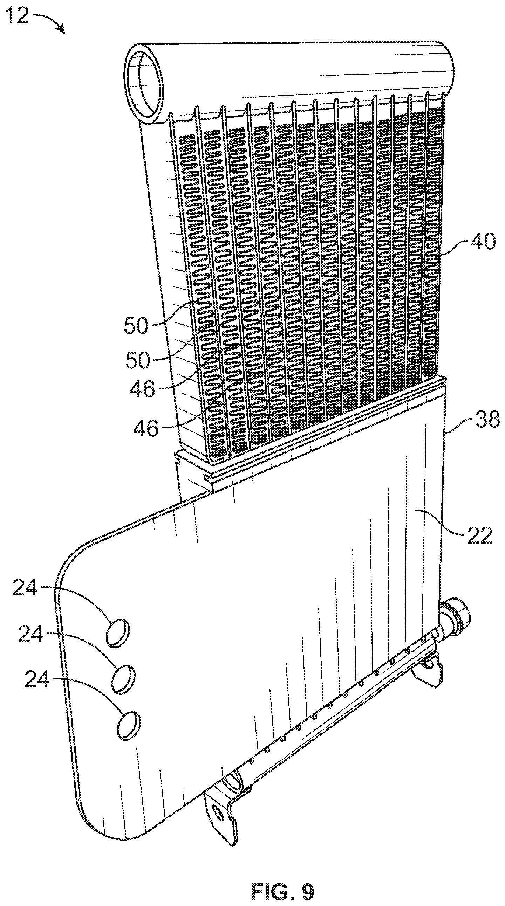

As shown in Figures 6C and 8-9, the active cooling system 12 may include a plurality of pipes 46 that are filled with a working fluid. The pipes 46 extend through the evaporator section 38 and the condenser section 40. As shown in Figure 8, metallic heat sinks 48 may be provided between the pipes 46 to convey heat into the evaporator section 38. Fins 50 may also be provided between the pipes 46 in the condenser section 40 to convey heat to the air 44 passing between the pipes 46. Preferably, the metallic heat sinks 48 in the evaporator section 38 are made of aluminum. As shown in Figure 9, the bus bar 22 may be pressed against the metallic heat sinks 48 to transfer heat from the bus bar 22 to the evaporator section 38. Although a dry fit or thermal paste may be used between the bus bar 22 and the evaporator section 38, it may be preferable for the bus bar 22 to be brazed to the metallic heatsinks 48. For example, a metallic brazing material may be deposited onto the metallic heat sinks 48 and/or the bus bar 22 and the bus bar 22 may be pressed against the metallic heat sinks 48 with the brazing material therebetween. The active cooling system 12 and the bus bar 22 made then be placed in an oven to melt the brazing material to braze the bus bar 22 to the metallic heat sinks 48.

While preferred embodiments of the inventions have been described, it should be understood that the inventions are not so limited, and modifications may be made without departing from the scope of the invention as set forth with the appended claims.

## Claims

1. A solid state circuit breaker (18), comprising:
a first power semiconductor (14);
a first active cooling system (12); and
a first bus bar (20) disposed between the first active cooling system (12) and the first power semiconductor (14), the first bus bar (20) being sandwiched between the first active cooling system (12) and the first power semiconductor (14) to conduct heat from the first power semiconductor (14) to the first active cooling system (12) through a thickness of the first bus bar (20), the first bus bar (20) being metallic and extending at least a portion beyond the first active cooling system (12) and the first power semiconductor (14) to provide a first exposed electrical connector (24), wherein the first active cooling system (12) comprises an evaporator section (38) pressed against the first bus bar (20) and a condenser section (40) extending beyond the first bus bar (20) and the first power semiconductor (14).

2. The solid state circuit breaker (18) according to claim 1, further comprising a fan (42) blowing air (44) through the condenser section (40).

3. The solid state circuit breaker (18) according to claim 1, wherein the first active cooling system (12) comprises a plurality of pipes (46) filled with a working fluid extending through the evaporator (38) and condenser sections (40), the evaporator section (38) comprising metallic heat sinks (48) extending between the pipes (46), the first bus bar (20) being pressed against the metallic heat sinks (48), preferably wherein the first bus bar (20) is brazed to the metallic heat sinks (48) and more preferably wherein the metallic heat sinks (48) comprise aluminum.

4. The solid state circuit breaker (18) according to claim 1, wherein the first bus bar (22)
comprises a copper plate (22) sandwiched between the first active cooling system (12) and the first power semiconductor (14), the first exposed electrical connector (24) being formed in a portion of the copper plate (22), preferably wherein the first exposed electrical connector (24) comprises a hole extending through the first bus bar (22).

5. The solid state circuit breaker (18) according to claim 1, further comprising a first electrical conductor (26) connected to the first exposed electrical connector (24), the first electrical conductor (26) applying a first voltage potential to the first bus bar (22), and the first bus bar (22) applying the first voltage potential to a first side of the first power semiconductor (14).

6. The solid state circuit breaker (18) according to claim 5, wherein the first voltage potential is also applied to the first active cooling system (12) by the first bus bar (22).

7. The solid state circuit breaker (18) according to claim 5, further comprising a second active cooling system (12) and a second bus bar (22),
wherein the first bus bar (22) is disposed against the first side of the first power semiconductor (14) and the second bus bar (22) is disposed against a second side of the first power semiconductor (14) opposite from the first side,
the second bus bar (22) being disposed between the second active cooling system (12) and the first power semiconductor (14), the second bus bar (22) being sandwiched between the second active cooling system (12) and the first power semiconductor (14) to conduct heat from the first power semiconductor (14) to the second active cooling system (12) through a thickness of the second bus bar (22), the second bus bar (22) being metallic and extending at least a portion beyond the second active cooling system (12) and the first power semiconductor (14) to provide a second exposed electrical connector (24),
a second electrical conductor (26) connected to the second exposed electrical connector (24), the second electrical conductor (24) applying a second voltage potential to the second bus bar (22), and the second bus bar (22) applying the second voltage potential to the second side of the first power semiconductor (14),
electrical current (28) thereby flowing from the first electrical conductor (26) through the first bus bar (22), the first side of the first power semiconductor (14), the first power semiconductor (14), the second side of the first power semiconductor (14) and the second bus bar (22) to the second electrical conductor (26).

8. The solid state circuit breaker (18) according to claim 1, wherein the first active cooling system (12) is a pulsating heat pipe, Cothex or hybrid Cothex; or wherein the first power semiconductor (14) comprises a IGCT (integrated gate-commutated thyristor), thyristor, A-IGCT (asymmetrical integrated gate-commutated thyristor), RB-IGCT (reverse blocking integrated gate-commutated thyristor) or GTO (gate turn-off); or further comprising:
a surge arrester (10) disposed within a center of the solid state circuit breaker (18); the first active cooling system (12) disposed against one side of the surge arrester (10) and a second active cooling system (12) disposed against an opposite side of the surge arrester (10); and
the first power semiconductor (14) disposed against the first active cooling system (12) on an opposite side from the surge arrester (10), and a second power semiconductor (14) disposed against the second active cooling system (12) on an opposite side from the surge arrester (10).

9. The solid state circuit breaker (18) according to claim 1, wherein the first bus bar (22) comprises a copper plate (22) sandwiched between the first active cooling system (12) and the first power semiconductor (14), the first exposed electrical connector (24) being formed in a portion of the copper plate (22), and further comprising a first electrical conductor (26) connected to the first exposed electrical connector (24), the first electrical conductor (26) applying a first voltage potential to the first bus bar (22) and the first bus bar (22) applying the first voltage potential to a first side of the first power semiconductor (14).

10. The solid state circuit breaker (18) according to claim 10, further comprising a fan (42) blowing air (44) through the condenser section (40), wherein the first active cooling system (12) comprises a plurality of pipes (46) filled with a working fluid extending through the evaporator (38) and condenser sections (40), the evaporator section (38) comprising metallic heat sinks (48) extending between the pipes (46), the first bus bar (22) being pressed against the metallic heat sinks (48).

11. The solid state circuit breaker (18) according to claim 10, wherein the first exposed electrical connector (24) comprises a hole extending through the first bus bar (22), and the first voltage potential is also applied to the first active cooling system (12) by the first bus bar (22).

12. The solid state circuit breaker (18) according to claim 11, further comprising a second active cooling system (12) and a second bus bar (22),
wherein the first bus bar (22) is disposed against the first side of the first power semiconductor (14) and the second bus bar (22) is disposed against a second side of the first power semiconductor (14) opposite from the first side,
the second bus bar (22) being disposed between the second active cooling system (12) and the first power semiconductor (14), the second bus bar (22) being sandwiched between the second active cooling system (12) and the first power semiconductor (14) to conduct heat from the first power semiconductor (14) to the second active cooling system (12) through a thickness of the second bus bar (22), the second bus bar (22) being metallic and extending at least a portion beyond the second active cooling system (12) and the first power semiconductor (14) to provide a second exposed electrical connector (24),
a second electrical conductor (26) connected to the second exposed electrical connector (24), the second electrical conductor (26) applying a second voltage potential to the second bus bar (22), and the second bus bar (22) applying the second voltage potential to the second side of the first power semiconductor (14),
electrical current (28) thereby flowing from the first electrical conductor (24) through the first bus bar (22), the first side of the first power semiconductor (14), the first power semiconductor (14), the second side of the first power semiconductor (14) and the second bus bar (22) to the second electrical conductor (26).

13. The solid state circuit breaker (18) according to claim 12, further comprising:
a surge arrester (10) disposed within a center of the solid state circuit breaker (18);
the first active cooling system (12) disposed against one side of the surge arrester (10) and a third active cooling system (12) disposed against an opposite side of the surge arrester (10); and
the first power semiconductor (14) disposed against the first active cooling system (12) on an opposite side from the surge arrester (10), and a second power semiconductor (14) disposed against the third active cooling system (12) on an opposite side from the surge arrester (10).

## Patentansprüche

1. Ein Halbleiter-Leistungsschalter (18), umfassend:
einen ersten Leistungshalbleiter (14);
ein erstes aktives Kühlsystem (12); und
eine erste Sammelschiene (20), die zwischen dem ersten aktiven Kühlsystem (12) und dem ersten Leistungshalbleiter (14) angeordnet ist, wobei die erste Sammelschiene (20) zwischen dem ersten aktiven Kühlsystem (12) und dem ersten Leistungshalbleiter (14) angeordnet ist, um Wärme vom ersten Leistungshalbleiter (14) zum ersten aktiven Kühlsystem (12) durch die Dicke der ersten Sammelschiene (20) hindurch zu leiten, wobei die erste Sammelschiene (20) metallisch ist und sich zumindest teilweise über das erste aktive Kühlsystem (12) und den ersten Leistungshalbleiter (14) hinaus erstreckt, um einen ersten freiliegenden elektrischen Anschluss (24) bereitzustellen, wobei das erste aktive Kühlsystem (12) einen Verdampferabschnitt (38), der gegen die erste Sammelschiene (20) gedrückt ist, und einen Kondensatorabschnitt (40) umfasst, der sich über die erste Sammelschiene (20) und den ersten Leistungshalbleiter (14) hinaus erstreckt.

2. Der Halbleiter-Leistungsschalter (18) nach Anspruch 1, ferner umfassend einen Lüfter (42), der Luft (44) durch den Kondensatorabschnitt (40) bläst.

3. Der Halbleiter-Leistungsschalter (18) nach Anspruch 1, wobei das erste aktive Kühlsystem (12) eine Vielzahl von mit einem Arbeitsfluid gefüllten Rohren (46) umfasst, die sich durch den Verdampferabschnitt (38) und die Kondensatorabschnitte (40) erstrecken, wobei der Verdampferabschnitt (38) metallische Kühlkörper (48) umfasst, die sich zwischen den Rohren (46) erstrecken, wobei die erste Sammelschiene (20) gegen die metallischen Kühlkörper (48) gedrückt wird, vorzugsweise wobei die erste Sammelschiene (20) mit den metallischen Kühlkörpern (48) verlötet ist und noch bevorzugter, wobei die metallischen Kühlkörper (48) aus Aluminium bestehen.

4. Der Halbleiter-Leistungsschalter (18) nach Anspruch 1, wobei die erste Sammelschiene (22)
eine Kupferplatte (22) umfasst, die zwischen dem ersten aktiven Kühlsystem (12) und dem ersten Leistungshalbleiter (14) angeordnet ist, wobei der erste freiliegende elektrische Anschluss (24) in einem Abschnitt der Kupferplatte (22) ausgebildet ist, vorzugsweise wobei der erste freiliegende elektrische Steckverbinder (24) umfasst eine sich durch die erste Sammelschiene (22) erstreckende Bohrung.

5. Der Halbleiter-Leistungsschalter (18) nach Anspruch 1, der ferner einen ersten elektrischen Leiter (26) umfasst, der mit dem ersten freiliegenden elektrischen Anschluss (24) verbunden ist, wobei der erste elektrische Leiter (26) ein erstes Spannungspotential an die erste Sammelschiene (22) anlegt und die erste Sammelschiene (22) das erste Spannungspotential an eine erste Seite des ersten Leistungshalbleiters (14) anlegt.

6. Der Halbleiter-Leistungsschalter (18) nach Anspruch 5, wobei das erste Spannungspotential ebenfalls über die erste Sammelschiene (22) an das erste aktive Kühlsystem (12) angelegt wird.

7. Der Halbleiter-Leistungsschalter (18) nach Anspruch 5, der ferner ein zweites aktives Kühlsystem (12) und eine zweite Sammelschiene (22) umfasst,
wobei die erste Sammelschiene (22) an der ersten Seite des ersten Leistungshalbleiters (14) und die zweite Sammelschiene (22) an einer der ersten Seite gegenüberliegenden zweiten Seite des ersten Leistungshalbleiters (14) angeordnet ist,
wobei die zweite Sammelschiene (22) zwischen dem zweiten aktiven Kühlsystem (12) und dem ersten Leistungshalbleiter (14) angeordnet ist, wobei die zweite Sammelschiene (22) zwischen dem zweiten aktiven Kühlsystem (12) und dem ersten Leistungshalbleiter (14) angeordnet ist, um Wärme vom ersten Leistungshalbleiter (14) zum zweiten aktiven Kühlsystem (12) durch die Dicke der zweiten Sammelschiene (22) hindurch zu leiten, wobei die zweite Sammelschiene (22) metallisch ist und sich zumindest teilweise über das zweite aktive Kühlsystem (12) und den ersten Leistungshalbleiter (14) hinaus erstreckt, um einen zweiten freiliegenden elektrischen Anschluss (24) bereitzustellen,
einen zweiten elektrischen Leiter (26), der mit dem zweiten freiliegenden elektrischen Anschluss (24) verbunden ist, wobei der zweite elektrische Leiter (24) ein zweites Spannungspotential an die zweite Sammelschiene (22) anlegt und die zweite Sammelschiene (22) das zweite Spannungspotential an die zweite Seite des ersten Leistungshalbleiters (14) anlegt,
wodurch elektrischer Strom (28) vom ersten elektrischen Leiter (26) durch die erste Sammelschiene (22), die erste Seite des ersten Leistungshalbleiters (14), den ersten Leistungshalbleiter (14), die zweite Seite des ersten Leistungshalbleiters (14) und die zweite Sammelschiene (22) zum zweiten elektrischen Leiter (26) fließt.

8. Der Halbleiter-Leistungsschalter (18) nach Anspruch 1, wobei das erste aktive Kühlsystem (12) ein pulsierendes Wärmerohr, Cothex oder Hybrid-Cothex ist; oder wobei der erste Leistungshalbleiter (14) einen IGCT (integrierten gate-kommutierten Thyristor), einen Thyristor, einen A-IGCT (asymmetrischen integrierten gate-kommutierten Thyristor), einen RB-IGCT (Reverse-Blocking-Integrated-Gate-Commutated-Thyristor) oder einen GTO (Gate-Turn-Off); oder ferner umfassend:
einen Überspannungsableiter (10), der in der Mitte des Leistungshalbleiterschalters (18) angeordnet ist;
das erste aktive Kühlsystem (12), das an einer Seite des Überspannungsableiters (10) angeordnet ist, und ein zweites aktives Kühlsystem (12), das an einer gegenüberliegenden Seite des Überspannungsableiters (10) angeordnet ist; und
einen ersten Leistungshalbleiter (14), der an dem ersten aktiven Kühlsystem (12) auf einer dem Überspannungsableiter (10) gegenüberliegenden Seite angeordnet ist, und einen zweiten Leistungshalbleiter (14), der an dem zweiten aktiven Kühlsystem (12) auf einer dem Überspannungsableiter (10) gegenüberliegenden Seite angeordnet ist.

9. Der Halbleiter-Leistungsschalter (18) nach Anspruch 1, wobei die erste Sammelschiene (22) eine Kupferplatte (22) umfasst, die zwischen dem ersten aktiven Kühlsystem (12) und dem ersten Leistungshalbleiter (14) angeordnet ist, wobei der erste freiliegende elektrische Anschluss (24) in einem Abschnitt der Kupferplatte (22) ausgebildet ist, und ferner einen ersten elektrischen Leiter (26) umfasst, der mit dem ersten freiliegenden elektrischen Anschluss (24) verbunden ist, wobei der erste elektrische Leiter (26) ein erstes Spannungspotential an die erste Sammelschiene (22) anlegt und die erste Sammelschiene (22) das erste Spannungspotential an eine erste Seite des ersten Leistungshalbleiters (14) anlegt.

10. Der Halbleiter-Leistungsschalter (18) nach Anspruch 10, der ferner einen Lüfter (42) umfasst, der Luft (44) durch den Kondensatorabschnitt (40) bläst, wobei das erste aktive Kühlsystem (12) eine Vielzahl von mit einem Arbeitsmedium gefüllten Rohren (46) umfasst, die sich durch den Verdampfer (38) und die Kondensatorabschnitte (40) erstrecken, wobei der Verdampferabschnitt (38) metallische Kühlkörper (48) umfasst, die sich zwischen den Rohren (46) erstrecken, und die erste Sammelschiene (22) gegen die metallischen Kühlkörper (48) gedrückt wird.

11. Der Halbleiter-Leistungsschalter (18) nach Anspruch 10, wobei der erste freiliegende elektrische Anschluss (24) eine sich durch die erste Sammelschiene (22) erstreckende Bohrung umfasst und das erste Spannungspotential ebenfalls über die erste Sammelschiene (22) an das erste aktive Kühlsystem (12) angelegt wird.

12. Der Halbleiter-Leistungsschalter (18) nach Anspruch 11, der ferner umfasst ein zweites aktives Kühlsystem (12) und eine zweite Sammelschiene (22),
wobei die erste Sammelschiene (22) an der ersten Seite des ersten Leistungshalbleiters (14) und die zweite Sammelschiene (22) an einer der ersten Seite gegenüberliegenden zweiten Seite des ersten Leistungshalbleiters (14) angeordnet ist,
wobei die zweite Sammelschiene (22) zwischen dem zweiten aktiven Kühlsystem (12) und dem ersten Leistungshalbleiter (14) angeordnet ist, wobei die zweite Sammelschiene (22) zwischen dem zweiten aktiven Kühlsystem (12) und dem ersten Leistungshalbleiter (14) angeordnet ist, um Wärme vom ersten Leistungshalbleiter (14) durch die Dicke der zweiten Sammelschiene (22) hindurch zum zweiten aktiven Kühlsystem (12) zu leiten, wobei die zweite Sammelschiene (22) metallisch ist und sich zumindest teilweise über das zweite aktive Kühlsystem (12) und den ersten Leistungshalbleiter (14) hinaus erstreckt, um einen zweiten freiliegenden elektrischen Anschluss (24) bereitzustellen,
wobei ein zweiter elektrischer Leiter (26) mit dem zweiten freiliegenden elektrischen Anschluss (24) verbunden ist, wobei der zweite elektrische Leiter (26) ein zweites Spannungspotential an die zweite Sammelschiene (22) anlegt und die zweite Sammelschiene (22) das zweite Spannungspotential an die zweite Seite des ersten Leistungshalbleiters (14) anlegt,
wodurch elektrischer Strom (28) vom ersten elektrischen Leiter (24) durch die erste Sammelschiene (22), die erste Seite des ersten Leistungshalbleiters (14), den ersten Leistungshalbleiter (14), die zweite Seite des ersten Leistungshalbleiters (14) und die zweite Sammelschiene (22) zum zweiten elektrischen Leiter (26) fließt.

13. Der Halbleiter-Leistungsschalter (18) nach Anspruch 12, ferner umfassend:
einen Überspannungsableiter (10), der in der Mitte des Leistungshalbleiterschalters (18) angeordnet ist;
das erste aktive Kühlsystem (12), das an einer Seite des Überspannungsableiters (10) angeordnet ist, und ein drittes aktives Kühlsystem (12), das an einer gegenüberliegenden Seite des Überspannungsableiters (10) angeordnet ist; und
ein erster Leistungshalbleiter (14), der auf der dem Überspannungsableiter (10) gegenüberliegenden Seite an dem ersten aktiven Kühlsystem (12) angeordnet ist, und ein zweiter Leistungshalbleiter (14), der auf der dem Überspannungsableiter (10) gegenüberliegenden Seite an dem dritten aktiven Kühlsystem (12) angeordnet ist.

## Revendications

1. Disjoncteur statique (18), comprenant :
un premier semi-conducteur de puissance (14) ;
un premier système de refroidissement actif (12) ; et
une première barre omnibus (20) disposée entre le premier système de refroidissement actif (12) et le premier semi-conducteur de puissance (14), la première barre omnibus (20) étant intercalée entre le premier système de refroidissement actif (12) et le premier semi-conducteur de puissance (14) afin de conduire la chaleur du premier semi-conducteur de puissance (14) au premier système de refroidissement actif (12) à travers une épaisseur de la première barre omnibus (20), la première barre omnibus (20) étant métallique et s'étendant au moins en partie au-delà du premier système de refroidissement actif (12) et du premier semi-conducteur de puissance (14) afin de fournir un premier connecteur électrique à découvert (24),
dans lequel le premier système de refroidissement actif (12) comprend une section évaporateur (38) pressée contre la première barre omnibus (20) et une section condenseur (40) s'étendant au-delà de la première barre omnibus (20) et du premier semi-conducteur de puissance (14).

2. Disjoncteur statique (18) selon la revendication 1, comprenant en outre un ventilateur (42) soufflant de l'air (44) à travers la section condenseur (40).

3. Disjoncteur statique (18) selon la revendication 1, dans lequel le premier système de refroidissement actif (12) comprend une pluralité de tubes (46) remplis d'un fluide de travail s'étendant à travers les sections évaporateur (38) et condenseur (40), la section évaporateur (38) comprenant des dissipateurs thermiques métalliques (48) s'étendant entre les tubes (46), la première barre omnibus (20) étant pressée contre les dissipateurs thermiques métalliques (48), de préférence dans lequel la première barre omnibus (20) est brasée aux dissipateurs thermiques métalliques (48) et de préférence encore dans lequel les dissipateurs thermiques métalliques (48) comprennent de l'aluminium.

4. Disjoncteur statique (18) selon la revendication 1, dans lequel la première barre omnibus (22) comprend une plaque de cuivre (22) intercalée entre le premier système de refroidissement actif (12) et le premier semi-conducteur de puissance (14), le premier connecteur électrique à découvert (24) étant formé dans une partie de la plaque de cuivre (22), de préférence dans lequel le premier connecteur électrique à découvert (24) comprend un trou s'étendant à travers la première barre omnibus (22).

5. Disjoncteur statique (18) selon la revendication 1, comprenant en outre un premier conducteur électrique (26) connecté au premier connecteur électrique à découvert (24), le premier conducteur électrique (26) appliquant un premier potentiel de tension à la première barre omnibus (22), et la première barre omnibus (22) appliquant le premier potentiel de tension à un premier côté du premier semi-conducteur de puissance (14).

6. Disjoncteur statique (18) selon la revendication 5, dans lequel le premier potentiel de tension est également appliqué au premier système de refroidissement actif (12) par la première barre omnibus (22).

7. Disjoncteur statique (18) selon la revendication 5, comprenant en outre un deuxième système de refroidissement actif (12) et une deuxième barre omnibus (22),
dans lequel la première barre omnibus (22) est disposée contre le premier côté du premier semi-conducteur de puissance (14) et la deuxième barre omnibus (22) est disposée contre un deuxième côté du premier semi-conducteur de puissance (14) opposé au premier côté,
la deuxième barre omnibus (22) étant disposée entre le deuxième système de refroidissement actif (12) et le premier semi-conducteur de puissance (14), la deuxième barre omnibus (22) étant intercalée entre le deuxième système de refroidissement actif (12) et le premier semi-conducteur de puissance (14) afin de conduire la chaleur du premier semi-conducteur de puissance (14) au deuxième système de refroidissement actif (12) à travers une épaisseur de la deuxième barre omnibus (22), la deuxième barre omnibus (22) étant métallique et s'étendant au moins en partie au-delà du deuxième système de refroidissement actif (12) et du premier semi-conducteur de puissance (14) afin de fournir un deuxième connecteur électrique à découvert (24),
un deuxième conducteur électrique (26) connecté au deuxième connecteur électrique à découvert (24), le deuxième conducteur électrique (24) appliquant un deuxième potentiel de tension à la deuxième barre omnibus (22), et la deuxième barre omnibus (22) appliquant le deuxième potentiel de tension au deuxième côté du premier semi-conducteur de puissance (14),
un courant électrique (28) circulant ainsi du premier conducteur électrique (26), à travers la première barre omnibus (22), le premier côté du premier semi-conducteur de puissance (14), le premier semi-conducteur de puissance (14), le deuxième côté du premier semi-conducteur de puissance (14) et la deuxième barre omnibus (22), jusqu'au deuxième conducteur électrique (26).

8. Disjoncteur statique (18) selon la revendication 1, dans lequel le premier système de refroidissement actif (12) est un caloduc pulsé, Cothex ou Cothex hybride ; ou dans lequel le premier semi-conducteur de puissance (14) comprend un IGCT (thyristor commuté par la gâchette intégrée), un thyristor, un A-IGCT (thyristor asymétrique commuté par la gâchette intégrée), un RB-IGCT (thyristor commuté par la gâchette intégrée à blocage inverse) ou un GTO (extinction par la gâchette) ; ou comprenant en outre :
un parasurtenseur (10) disposé dans une partie centrale du disjoncteur statique (18) ;
le premier système de refroidissement actif (12) disposé contre un côté du parasurtenseur (10) et un deuxième système de refroidissement actif (12) disposé contre un côté opposé du parasurtenseur (10) ; et
le premier semi-conducteur de puissance (14) disposé contre le premier système de refroidissement actif (12) sur un côté opposé au parasurtenseur (10), et un deuxième semi-conducteur de puissance (14) disposé contre le deuxième système de refroidissement actif (12) sur un côté opposé au parasurtenseur (10).

9. Disjoncteur statique (18) selon la revendication 1, dans lequel la première barre omnibus (22) comprend une plaque de cuivre (22) intercalée entre le premier système de refroidissement actif (12) et le premier semi-conducteur de puissance (14), le premier connecteur électrique à découvert (24) étant formé dans une partie de la plaque de cuivre (22), et comprenant en outre un premier conducteur électrique (26) connecté au premier connecteur électrique à découvert (24), le premier conducteur électrique (26) appliquant un premier potentiel de tension à la première barre omnibus (22) et la première barre omnibus (22) appliquant le premier potentiel de tension à un premier côté du premier semi-conducteur de puissance (14).

10. Disjoncteur statique (18) selon la revendication 10, comprenant en outre un ventilateur (42) soufflant de l'air (44) à travers la section condenseur (40), dans lequel le premier système de refroidissement actif (12) comprend une pluralité de tubes (46) remplis d'un fluide de travail s'étendant à travers les sections évaporateur (38) et condenseur (40), la section évaporateur (38) comprenant des dissipateurs thermiques métalliques (48) s'étendant entre les tubes (46), la première barre omnibus (22) étant pressée contre les dissipateurs thermiques métalliques (48).

11. Disjoncteur statique (18) selon la revendication 10, dans lequel le premier connecteur électrique à découvert (24) comprend un trou s'étendant à travers la première barre omnibus (22), et le premier potentiel de tension est également appliqué au premier système de refroidissement actif (12) par la première barre omnibus (22).

12. Disjoncteur statique (18) selon la revendication 11, comprenant en outre un deuxième système de refroidissement actif (12) et une deuxième barre omnibus (22),
dans lequel la première barre omnibus (22) est disposée contre le premier côté du premier semi-conducteur de puissance (14) et la deuxième barre omnibus (22) est disposée contre un deuxième côté du premier semi-conducteur de puissance (14) opposé au premier côté,
la deuxième barre omnibus (22) étant disposée entre le deuxième système de refroidissement actif (12) et le premier semi-conducteur de puissance (14), la deuxième barre omnibus (22) étant intercalée entre le deuxième système de refroidissement actif (12) et le premier semi-conducteur de puissance (14) afin de conduire la chaleur du premier semi-conducteur de puissance (14) au deuxième système de refroidissement actif (12) à travers une épaisseur de la deuxième barre omnibus (22), la deuxième barre omnibus (22) étant métallique et s'étendant au moins en partie au-delà du deuxième système de refroidissement actif (12) et du premier semi-conducteur de puissance (14) afin de fournir un deuxième connecteur électrique à découvert (24),
un deuxième conducteur électrique (26) connecté au deuxième connecteur électrique à découvert (24), le deuxième conducteur électrique (26) appliquant un deuxième potentiel de tension à la deuxième barre omnibus (22), et la deuxième barre omnibus (22) appliquant le deuxième potentiel de tension au deuxième côté du premier semi-conducteur de puissance (14),
un courant électrique (28) circulant ainsi du premier conducteur électrique (24), à travers la première barre omnibus (22), le premier côté du premier semi-conducteur de puissance (14), le premier semi-conducteur de puissance (14), le deuxième côté du premier semi-conducteur de puissance (14) et la deuxième barre omnibus (22), jusqu'au deuxième conducteur électrique (26).

13. Disjoncteur statique (18) selon la revendication 12, comprenant en outre :
un parasurtenseur (10) disposé dans une partie centrale du disjoncteur statique (18) ;
le premier système de refroidissement actif (12) disposé contre un côté du parasurtenseur (10) et un troisième système de refroidissement actif (12) disposé contre un côté opposé du parasurtenseur (10) ; et
le premier semi-conducteur de puissance (14) disposé contre le premier système de refroidissement actif (12) sur un côté opposé au parasurtenseur (10), et un deuxième semi-conducteur de puissance (14) disposé contre le troisième système de refroidissement actif (12) sur un côté opposé au parasurtenseur (10).
